Europäisches Patentamt

European Patent Office

Office européen des brevets

(11) Publication number: **0 380 237**
**A1**

## EUROPEAN PATENT APPLICATION

(21) Application number: **90300533.8**

(22) Date of filing: **18.01.90**

(51) Int. Cl.⁵: **H05K 1/18, H01G 1/147, H01R 9/09, G11C 11/21**

(30) Priority: **23.01.89 JP 6179/89 U**

(43) Date of publication of application:
**01.08.90 Bulletin 90/31**

(84) Designated Contracting States:
**DE FR GB**

(71) Applicant: **SEIKO ELECTRONIC COMPONENTS LTD.**
**30-1, Nishitaga 5-chome Taihaku-ku Sendai-shi Miyagi-ken(JP)**

(72) Inventor: **Takeda, Kazutoshi, c/o Seiko Electronic Components Ltd., 30-1, Nishitaga, 5-chome Taihaku-ku, Sendai-shi, Miyagi-ken(JP)**

(74) Representative: **Miller, Joseph et al J. MILLER & CO. Lincoln House 296-302 High Holborn London WC1V 7JH(GB)**

(54) Power source unit.

(57) A power source unit comprising a power source element (10) having a positive terminal (1) and a negative terminal (4); and a pair of connecting terminal pieces (8) each of which has a base portion (20) connected to the respective terminal (1,4) of the power source element (10), each connecting terminal piece (8) having an end portion (19) which extends longitudinally of the base portion (20), at least the adjacent parts of the base portion (20) and end portion (19) being planar characterised in that the planes of the said adjacent parts are substantially at right angles to each other.

## FIG. 1A

## POWER SOURCE UNIT

This invention concerns a power source unit, e.g. for connection to a circuit board.

Power source units are known comprising a power source element having a positive terminal and a negative terminal, and a pair of connecting terminal pieces each of which has a base portion connected to the respective terminal of the power source element and an end portion connected to a circuit board. In the known units, however, the total thickness or height of the power source element and circuit board has been relatively great and the mechanical strength of the connection therebetween has been relatively small.

According, therefore, to the present invention, there is provided a power source unit comprising a power source element having a positive terminal and a negative terminal; and a pair of connecting terminal pieces each of which has a base portion connected to the respective terminal of the power source element, each connecting terminal piece having an end portion which extends longitudinally of the base portion, at least the adjacent parts of the base portion and end portion being planar characterised in that the planes of the said adjacent parts are substantially at right angles to each other.

Preferably, each connecting terminal piece has an end portion which is integral with the base portion and which has been twisted with respect thereto.

The end portion of each connecting terminal piece is preferably connected to a circuit board.

The power source element may comprise a battery of the button type having positive and negative terminal faces on opposite sides thereof.

Each base portion may have a step portion which is bonded to the respective terminal of the power source element.

Moreover, each base portion may be welded to the respective terminal of the power source element.

Each connecting terminal piece may comprise an elongated member a major portion of whose length is constituted by the base portion and a minor portion of whose length is constituted by the end portion.

Each end portion preferably has a plating film on at least one face thereof.

Each connecting terminal piece may either be formed from a rod by pressing or from strip material by folding and punching.

The invention is illustrated, merely by way of example, in the accompanying drawings, in which:-

Figure 1A is a sectional view showing one embodiment of a power source unit according to the present invention;

Figure 1B is a plan view of the embodiment of Figure 1A;

Figure 2A is a sectional view showing the power source unit of Figures 1A and 1B mounted on a circuit board;

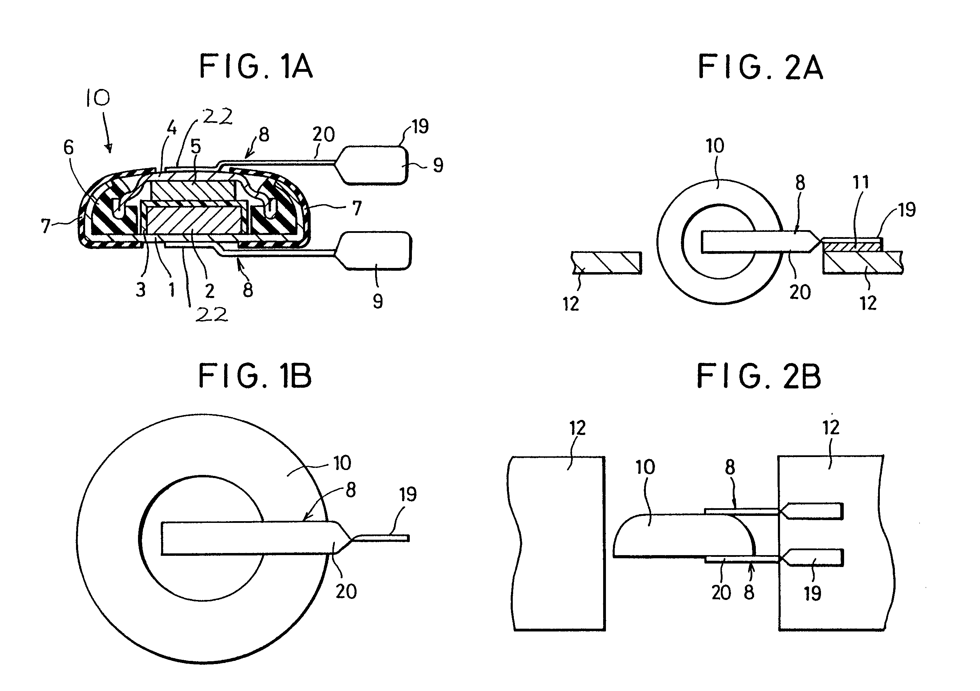

. Figure 2B is a plan view of the structure shown in Figure 2A;

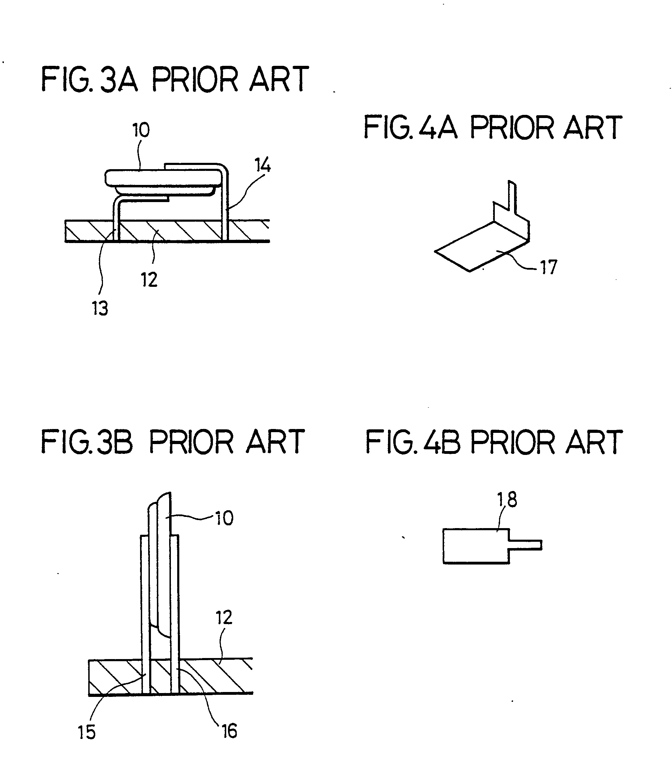

Figure 3A is a sectional view showing a known power source unit mounted on a circuit board;

Figure 3B is a sectional view showing another known power source unit mounted on a circuit board;

Figure 4A is a perspective view showing a known connecting terminal piece which may be used in the Figure 3A construction;

Figure 4B is a perspective view showing another known connecting terminal piece which may be used in the Figure 3B construction;

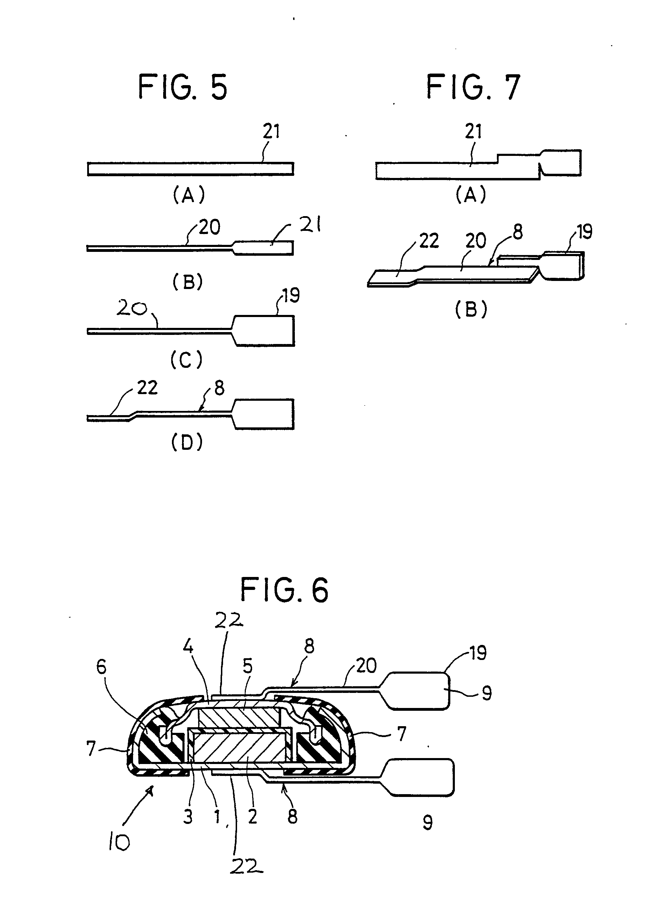

Figure 5 illustrates the manufacturing steps in one method of making a connecting terminal piece for use in the present invention;

Figure 6 is a sectional view showing another embodiment of a power source unit according to the present invention; and

Figure 7 illustrates the manufacturing steps in another method of making a connecting terminal piece for use in the present invention.

Two known power source units are shown respectively in Figures 3A and 3B.

The Figure 3A construction is comprised of a power source element 10; a negative connecting terminal piece 13 and a positive connecting terminal piece 14 each of which is welded to the element 10; and a circuit board 12. The element 10 is mounted parallel to the circuit board 12. The pair of connecting terminal pieces 13 and 14 are inserted into the circuit board 12 and are soldered thereto, if necessary.

The Figure 3B construction is comprised of a power source element 10; a negative connecting terminal piece 15 and a positive connecting terminal piece 16 each of which is welded to the element 10; and a circuit board 12. The element 10 is mounted perpendicularly to the circuit board 12. The pair of connecting terminal pieces 15 and 16 are inserted into the circuit board 12 and are soldered thereto, if necessary.

The known connecting terminal pieces which are respectively used in the constructions of Figures 3A and 3B are shown in Figures 4A and 4B.

Referring to Figure 4A, a folded connecting terminal piece 17 has a relatively great width of the order of 3mm to 4mm and is formed so that a tip end portion thereof has a relatively small width of 0.75mm. This tip end portion is provided with solder plating. if necessary.

Referring to Figure 4B, a planar connecting terminal piece 18 has a similar shape and dimensions to those of the connecting terminal piece 17.

Each of the known power source units is arranged on a circuit board so that the total thickness or height of the power source unit and the circuit board is relatively great, thereby causing the final product which incorporates these parts to be very thick. Further, each of the known connecting terminal pieces has a narrow tip end portion of a relatively small mechanical strength, thereby involving the risk that there will be folding or bending of the tip end portion and deformation thereof.

In Figure 2A there is therefore shown a sectional view of a power source unit according to the present invention mounted on a circuit board. In Figure 2A, the power source unit is comprised of a power source element 10 and a connecting terminal piece 8 which are fixed to a circuit board 12 through a solder bonding portion 11. As seen in Figure 2A, the power source element 10 is disposed in a recess of the circuit board 12 (or it could be disposed outside the periphery of the circuit board 12) so as to reduce the total height of the circuit board containing the power source element 10 to thereby reduce the size of a final product utilizing the circuit board 12.

Figure 2B is a plan view of the structure shown in Figure 2A. The power source element 10 is provided with a pair of the connecting terminal pieces 8 connected to the circuit board 12. As seen in Figure 2B, each connecting terminal piece 8 has a planar end portion 19 having a relatively large area which is effective to increase the bonding strength by soldering between the end portion 19 of the connecting terminal piece 8 and the circuit board 12. In addition to the fact that the bonding strength between the connecting terminal piece 8 and the circuit board 12 is considerable, the connecting terminal piece 8 itself has a strengthened construction arising from the fact that the plane of a substantially planar supporting or base portion 20 of the piece 8 is arranged perpendicular to that of the end portion 19, so that the piece 8 is effective to provide adequate support for the weight of the power source element 10. Moreover, the end portion 19 of the connecting terminal piece 8 may be coated with a tin plating film or with a solder plating film which facilitates mounting it on the circuit board and improves the bonding strength.

Embodiments

Hereinafter embodiments of the present invention are described with reference to the drawings.

## Embodiment 1

Figures 1A and 1B are sectional and plan views, respectively, of one embodiment of the power source unit according to the present invention. Referring to these Figures, the power source element 10 is composed of a battery of the button type, for example, CR1220 (voltage 3V, standard capacity 35mAH). The battery is comprised of a positive terminal casing 1, a positive active mixture 2 disposed within a separator 3, a negative terminal casing 4, a lithium film 5, and a gasket 6 and a thermally shrinkable tube 7 for insulating the positive and negative terminals from each other while connecting them together. A pair of connecting terminal pieces 8 have substantially planar base portions 20 provided with step portions 22 which are welded to the face of the positive terminal casing 1 and to the face of the negative terminal casing 4, respectively, with a bonding strength of more than 2kg, the said faces being disposed on opposite sides of the power source element 10. Each connecting terminal piece 8 has an end portion 19 which is twisted relative to the substantially planar base portion 20 thereof by substantially 90° and is coated on at least one face thereof with a solder plating 9. That is to say, each end portion 19 is integral with the respective base portion 20 and extends longitudinally of the latter, the adjacent planar parts of the base portion 20 and end portion 19 having been relatively twisted so that they are substantially at right angles to each other.

As shown in Figure 2B, the power source unit including the element 10 is mounted on the circuit board 12 through the connecting terminal pieces 8. Each connecting terminal piece 8 is composed of a strip of thin plate made of nickel or stainless steel and has a thickness of 0.1 - 0.2mm and a uniform width of 2-4mm. As indicated above, the connecting terminal piece 8 thus has an end portion 19 which is coated with thin plating or solder plating film 9 on one or both of the faces thereof and which is twisted through 90°.

## Embodiment 2

Figure 5 shows one embodiment of the manufacturing steps which may be used to produce a connecting terminal piece which may be used in a power source unit according to the present invention. In the first step (A), there is provided a connecting terminal member 21 composed of an elongated rod made of stainless steel and having a diameter of 1.0mm Ø. In the second step (B), a major part of the length of the rod 21 is formed by pressing into a planar base portion 20 having a thickness of 0.2mm and a width of 4mm. Next in the third step (C), the remaining minor part of the length of the rod is formed by pressing in a direction parallel to the plane of the base portion 20 into a planar end portion 19 which extends longitudinally of the base portion 20 and which has the same thickness of 0.2mm and the same width of 4mm as the latter. Thus, the plane of the base portion 20 is twisted perpendicularly to that of the end portion 19. Lastly in the fourth step (D), an end section of the base portion 20 is formed by punching into a step portion 22.

Figure 6 is a sectional view showing another embodiment of a power source unit according to the present invention utilizing the connecting terminal pieces produced by the above described method. In similar manner to the first embodiment, the pair of connecting terminal pieces 8 are welded at their step portions 22 to the face of negative terminal casing 4 and the face of positive terminal casing 1, respectively, to constitute a power source unit such that the respective end portions 19 are arranged perpendicularly to the base portion 20 so that the power source unit can be mounted by means of the end portions 19 in a recess of a circuit board or outside the circuit board around the periphery. Moreover, the end portion 19 of each connecting terminal piece 8 is coated on one or both of its faces with a tin plating or solder plating film which facilitates the mounting of the power source unit on the circuit board and increases the bonding strength.

Embodiment 3

Figure 7 illustrates the manufacturing steps of another method of making a connecting terminal piece which may be used in a power source unit according to the present invention. In the first step (A), a stainless steel plate is die-punched to form a connecting terminal member 21. In the second step (B), by folding and punching of the member 21, the connecting terminal piece 8 is shaped so that it has a base portion 20, an end portion 19 perpendicular to the base portion 20, and a step portion 22. The thus formed connecting terminal pieces 8 are utilized to produce a power source unit in a similar way to the first embodiment, thereby achieving the same effect.

The connecting terminal piece can be bonded to the power source element by pressure bonding, soldering and so on instead of welding. These bonding methods can be suitably selected to achieve the same inventive effect.

The power source element may be comprised of a battery e.g. of the button type, electric double layer capacitor and so on. The power source element may have various shapes such as cylindrical, pin-like, cubic, and paper-like ones.

In the embodiments of a power source unit according to the present invention described above, the connecting terminal piece has a substantially planar base portion bonded to the power source element and a substantially planar end portion twisted or otherwise arranged perpendicular to the base portion and designed to be connected to a circuit board etc. As a result of such a construction, the power source unit can be mounted on the circuit board so that the total height of the mounting structure and the circuit board can be reduced and so that the power source element can be firmly connected with increased strength to the circuit board.

The present invention can be applied to various electronic instruments and thus has great industrial value.

## Claims

1. A power source unit comprising a power source element (10) having a positive terminal (1) and a negative terminal (4); and a pair of connecting terminal pieces (8) each of which has a base portion (20) connected to the respective terminal (1,4) of the power source element (10), each connecting terminal piece (8) having an end portion (19) which extends longitudinally of the base portion (20), at least the adjacent parts of the base portion (20) and end portion (19) being planar characterised in that the planes of the said adjacent parts are substantially at right angles to each other.

2. A power source unit as claimed in claim 1 characterised in that each connecting terminal piece (8) has an end portion (19) which is integral with the base portion (20) and which has been twisted with respect thereto.

3. A power source unit as claimed in claim 1 or 2 characterised in that the end portion (19) of each connecting terminal piece (8) is connected to a circuit board (12).

4. A power source unit as claimed in any preceding claim characterised in that the power source element (10) comprises a battery of the button type having positive and negative terminal faces (1,4) on opposite sides thereof.

5. A power source unit as claimed in any preceding claim characterised in that each base portion (20) has a step portion (22) which is bonded to the respective terminal (1,4) of the power source element (10).

6. A power source unit as claimed in any preceding claim characterised in that each base portion (20) is welded to the respective terminal (1,4) of the power source element (10).

7. A power source unit as claimed in any preceding claim characterised in that each connecting terminal piece (8) comprises an elongated member a major portion of whose length is constituted by the base portion (20) and a minor portion of whose length is constituted by the end portion (19).

8. A power source unit as claimed in any preceding claim characterised in that each end portion (19) has a plating film (9) on at least one face thereof.

9. A power source unit as claimed in any preceding claim characterised in that each connecting terminal piece (8) has been formed from a rod by pressing.

10. A power source unit as claimed in claim 1 in which each connecting terminal piece (8) is formed from strip material by folding and punching.

11. A power source unit comprising:
power source element (10) having a positive terminal (1) and a negative terminal (4); and
a pair of connecting terminal pieces (8), each having a planar base portion (20) bonded to the respective terminal of the power source element (10) and a planar top end portion (19) twisted perpendicular to the planar base portion (20).

# FIG. 1A

# FIG. 2A

# FIG. 1B

# FIG. 2B

EP 0 380 237 A1

## FIG. 3A PRIOR ART

10

14

13

12

## FIG. 4A PRIOR ART

17

## FIG. 3B PRIOR ART

10

12

15

16

## FIG. 4B PRIOR ART

18

# FIG. 5

(A)

(B)

(C)

(D)

# FIG. 7

(A)

(B)

# FIG. 6

| | DOCUMENTS CONSIDERED TO BE RELEVANT | | EP 90300533.8 |

| Category | Citation of document with indication, where appropriate, of relevant passages | Relevant to claim | CLASSIFICATION OF THE APPLICATION (Int. Cl.⁵) |
|---|---|---|---|
| A | GB - A - 2 169 448 (ROGERS CORPORATION) * Fig. 4,5; page 3, lines 20-44; claims 1,5 * -- | 1,11 | H 05 K 1/18 H 01 G 1/147 H 01 R 9/09 G 11 C 11/21 |
| A | GB - A - 2 202 682 (SMITHS INDUSTRIES PUBLIC LIMITED COMPANY) * Page 2, lines 26-28; page 3, lines 1-9; claims 1,3; fig. 1,4,5 * -- | 1-3,11 | |
| A | CH - B5 - 644 990 (FABRIQUES D'HORLOGERIE DE FONTAINEMELON S.A.) ---- | | |

**TECHNICAL FIELDS SEARCHED (Int. Cl.⁵)**

H 05 K 1/00
H 01 G 1/00
H 01 R 9/00
G 11 C 11/00

The present search report has been drawn up for all claims

| Place of search | Date of completion of the search | Examiner |
|---|---|---|
| VIENNA | 28-03-1990 | SCHMIDT |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82